# Europäisches Patentamt
# European Patent Office
# Office européen des brevets

(19)

(11) Numéro de publication : **0 349 420 B1**

(12)

# FASCICULE DE BREVET EUROPEEN

(45) Date de publication du fascicule du brevet :
**29.07.92 Bulletin 92/31**

(51) Int. Cl.⁵ : **C23C 10/08**, C23C 10/50

(21) Numéro de dépôt : **89401841.5**

(22) Date de dépôt : **28.06.89**

(54) Procédé et dispositif de protection simultanée des surfaces internes et externes, notamment par aluminisation de pièces en alliages résistant à chaud, à base de Ni, Co ou Fe.

(30) Priorité : **30.06.88 FR 8808801**

(43) Date de publication de la demande :
**03.01.90 Bulletin 90/01**

(45) Mention de la délivrance du brevet :
**29.07.92 Bulletin 92/31**

(84) Etats contractants désignés :
**DE FR GB**

(56) Documents cités :
**EP-A- 0 024 802**
**FR-A- 2 306 276**
**FR-A- 2 576 916**
**GB-A- 827 132**
**US-A- 2 816 048**
**US-A- 2 887 407**

(56) Documents cités :
**REVUE DE METALLURGIE: MEMOIRES ET ETUDES SCIENTIFIQUES, vol. 85, no. 6, juin 1988, pages 327-335, Paris, FR; A. GALERIE etal.: "Aspects thermodynamiques de la cémentation activée en caisse: cas de l'aluminisation ou de la boruration du fer en cément-fluoré"**

(73) Titulaire : **SOCIETE NATIONALE D'ETUDE ET DE CONSTRUCTION DE MOTEURS D'AVIATION, "S.N.E.C.M.A."**
**2, Boulevard du Général Martial Valin**
**F-75015 Paris (FR)**

(72) Inventeur : **Fournes, Jean-Paul**
**17, rue de la Messe Dannemois**
**F-91490 Milly la Fôret (FR)**
Inventeur : **Morbioli, René, Jean**
**36, rue du Bas-Coudray**
**F-91100 Corbeil (FR)**

(74) Mandataire : **Moinat, François et al**
**S.N.E.C.M.A. Service des Brevets Boîte Postale 81**
**F-91003 Evry Cédex (FR)**

EP 0 349 420 B1

## Description

L'invention concerne un procédé de dépôt simultané d'un revêtement protecteur, notamment à base d'aluminium, à la fois sur les surfaces externes et internes de pièces en alliages résistant à chaud, notamment à base de nickel, cobalt ou fer. Elle concerne également un dispositif adapté à la mise en oeuvre dudit procédé.

FR-A-1 433 497 décrit un procédé d'aluminisation en phase vapeur selon lequel l'aluminium déposé est transféré sans contact solide-solide entre le donneur contenant le métal à déposer et la pièce à revêtir, le donneur réagissant avec un halogénure, notamment un fluorure.

D'autres procédés plus récents, dont un exemple est fourni par US-A-4 132 816 et US-A-4 148 275, proposent une solution pour obtenir une protection améliorée des surfaces internes de pièces creuses, notamment des aubes de turbine refroidies présentant des circuits internes, fins et complexes. Aucun de ces procédés connus ne donne toutefois entière satisfaction. Notamment US-A- 4 132 816 et US-A- 4 148 275 imposent des modalités complexes de mise en oeuvre utilisant des boites à deux compartiments et deux sources distinctes de donneur lorsqu'on doit réaliser une protection à la fois sur des surfaces externes et sur des surfaces internes de pièces.

(A) En outre, FR-A- 2 306 276 concerne un procédé de dépôt de revêtement utilisant un halogénure d'activation au contact d'une poudre granulaire entourant les pièces. La pièce peut être tenue hors du contact des particules. Parmi des halogénures connus, $AlF_3$ est préféré et dans tous les cas un mélange unique est utilisé.

Des résultats améliorés et une simplification de la mise en oeuvre sont obtenus par le procédé consistant

– (a) à chauffer à une température supérieure à 1000°C une boîte contenant, de manière séparée, les pièces à revêtir, un corps constituant le donneur du métal à déposer, et un corps constituant un activateur, composé au moins de fluorure de chrome, $F_3 Cr$, sous forme de poudre anhydre constituant une source de fluor ;

– (b) à établir une circulation dans la boîte des vapeurs fluorées obtenues, d'une part après décomposition thermique de $F_3 Cr$ et d'autre part, comportant le fluorure volatil après passage sur ledit donneur, en introduisant dans ladite boîte un débit contrôlé d'un gaz porteur réducteur ou neutre, de manière à obtenir par le contact desdites vapeurs métallisées avec les surfaces externes et internes des pièces un revêtement protecteur.

Avantageusement, avant l'application dudit procédé conforme à l'invention, une étape antérieure peut permettre d'effectuer un revêtement préalable, notamment des surfaces externes des pièces à revêtir, notamment à base de Cr, Pt ou dépôt complexe de type M Cr Al Y, obtenu par tout procédé connu en soi.

Un dispositif adapté à la mise en oeuvre dudit procédé conforme à l'invention se compose d'une boîte placée dans une enceinte susceptible d'être chauffée et remplie d'un gaz protecteur de type argon, éventuellement soumis à un débit contrôlé de circulation. Ladite boîte comporte, à sa partie inférieure, une rampe, raccordée à une alimentation externe sous débit contrôlé, de distribution d'un gaz porteur réducteur ou neutre, par exemple argon. Au-dessus, la boîte comporte des grilles-supports portant d'une part, de la poudre de fluorure de chrome $F_3 Cr$ anhydre,éventuellement mélangée à un support inerte de type $Al_2O_3$ et d'autre part, un donneur solide sous forme de granules d'un alliage du métal à déposer, notamment aluminium. A la partie supérieure de la boîte, sont placées les pièces à revêtir, les orifices de sortie des circuits internes des pièces étant tournés vers l'admission du flux de la phase gazeuse circulant dans la boîte. Selon l'effet recherché, les pièces sont entièrement immergées dans la boîte ou des parties non revêtues sont disposées à l'extérieur de la boîte et sont, éventuellement, recouvertes d'un cache.

D'autres caractéristiques et avantages de l'invention seront mieux compris à la lecture de la description qui va suivre d'un exemple de réalisation du procédé conforme à l'invention et d'un dispositif de mise en oeuvre dudit procédé, en référence au dessin annexé sur lequel :

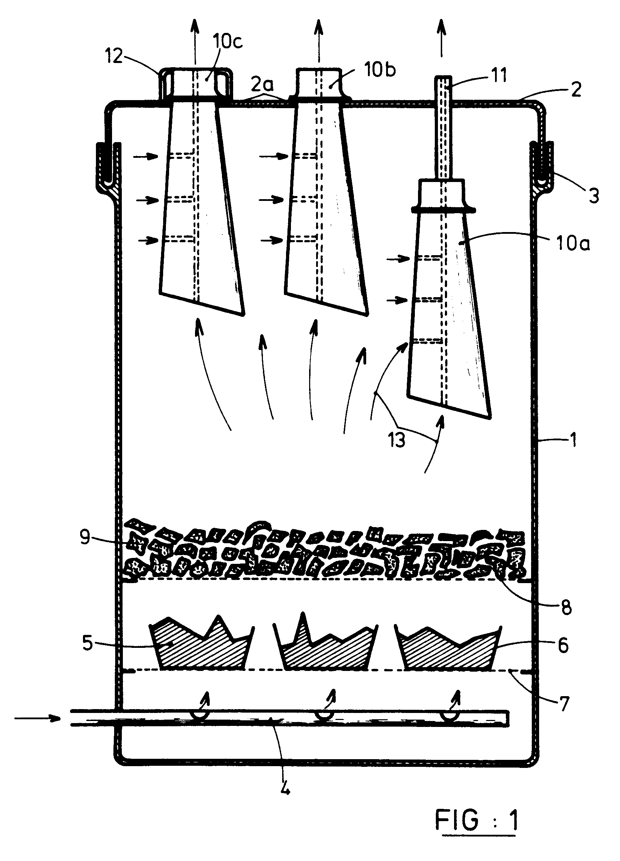

– la figure 1 représente une vue schématique en coupe axiale d'une boîte destinée à la mise en oeuvre du procédé de dépôt simultané d'un revêtement protecteur à la fois sur les surfaces externes et internes de pièces en alliages résistant à chaud.

Dans certaines applications des pièces en alliages résistant à chaud, à base de Ni, Co ou Fe, notamment aux moteurs aéronautiques, il est souvent nécessaire de concilier de bonnes caractéristiques de tenue mécanique à chaud et de tenue aux agressions provenant de l'environnement sous forme d'oxydation ou de corrosion de divers agents. Ces exigences conduisent à prévoir sur ce type de pièces un revêtement protecteur. Un procédé couramment utilisé selon FR-A-1 433 497 de dépôt en phase vapeur s'est révélé inefficace lorsqu'il s'agit d'étendre ce dépôt protecteur sur les surfaces internes de pièces complexes dont des exemples d'applications sur moteurs aéronautiques sont fournis par des rampes de distribution de carburant ou par des aubes refroidies de turbine comportant des circuits internes, fins et complexes. Le procédé conforme à l'invention permet d'obtenir le dépôt simultané d'un revêtement protecteur à la fois sur les surfaces externes et les surfaces internes de ce type de pièces, dans des conditions facilitant la mise en oeuvre tout en assurant l'obtention de résultats satisfaisants.

Le dispositif de mise en oeuvre représenté schématiquement à la figure 1 comporte une boîte 1 munie d'un couvercle 2 coopérant au niveau d'un rebord 3. Cette boîte 1 est placée dans une enceinte de traitement de tout type connu dans une atmosphère protectrice, par exemple sous argon, ladite enceinte étant équipée de moyens de chauffage, notamment électriques. A la partie inférieure de la boîte 1 est placée une rampe 4 raccordée à un moyen externe de tout type connu d'alimentation en gaz porteur qui peut être de type réducteur ou neutre, par exemple et de préférence de l'argon. L'arrivée à la rampe de distribution 4 est munie d'un moyen connu de réglage du débit de gaz, par exemple une vanne. Le réglage de ce débit tient compte du volume de la boîte 1, de son taux de remplissage en pièces à revêtir et peut éventuellement être déterminé par un essai simple à réaliser, une circulation suffisante correspondant à la qualité recherchée du revêtement obtenu. Au-dessus, est disposé un lit 5 de fluorure de chrome $F_3$ Cr, sous forme de poudre anhydre, éventuellement mélangée à un support inerte de type $Al_2 O_3$, placé par exemple dans des coupelles 6 posées sur une grille-support 7. Une grille-support supérieure 8 porte un donneur 9 grossièrement concassé, par exemple sous forme de granules de dimensions supérieures à quatre millimètres et qui peut être, lorsque le métal à déposer est l'aluminium, en un alliage de type CA 30, à 70% Cr et 30% Al, en pourcentages pondéraux de composition. A la partie supérieure de la boîte 1, sont disposées les pièces 10 à revêtir. Lorsqu'une protection complète de la pièce est recherchée, les pièces, telles que 10a représentée à la figure 1, sont complètement immergées dans la boîte 1 et peuvent être suspendues par tout moyen connu, par exemple un support 11 dans lequel est ménagé un passage permettant la circulation du gaz de l'intérieur de la pièce vers l'extérieur de la boîte. Le support 11 peut notamment être constitué par un tube. Lorsqu'une protection est prévue avec épargne, la partie non revêtue est maintenue à l'extérieur de la boîte 1, comme dans le cas des pièces 10b et 10c représentées à la figure 1, traversant des passages 2a ménagés sur le couvercle 2 de la boîte 1. Un cache tel que 12 peut être utilisé pour masquer la partie de pièce non revêtue. Dans certains cas, une circulation externe à faible débit du gaz protecteur suffit pour que le courant de gaz non réactif créé autour de la partie non revêtue, par exemple de la pièce 10b, empêche tout dépôt sur cette partie.

Le procédé de protection conforme à l'invention utilisant un dispositif du type qui vient d'être décrit se déroule de la manière ci-après décrite.

L'enceinte de traitement contenant la boîte 1 est portée à une température supérieure à 1000°C, à une vitesse de montée approximative de 17°C par minute. Une température de maintien couramment utilisée selon l'invention et donnant des résultats satisfaisants est de 1150°C. A cette température, la décomposition thermique du fluorure de chrome $F_3$ Cr utilisé est lente, progressive et constante. En fonction des volumes respectifs en présence, la présence d'$Al_2 O_3$ peut éventuellement modérer le débit des vapeurs fluorées obtenues. Sous l'influence du courant d'argon débité dans la boîte 1, il se produit à partir de ce moment, un balayage continu du donneur 9 qui fournit du fluorure d'aluminium très volatil, puis, des pièces 10 à revêtir, la circulation se faisant notamment à l'intérieur desdites pièces 10, de manière régulière et continue durant le temps de maintien du traitement. Pour une température de 1150°C, un temps de maintien de deux heures est généralement suffisant. Des températures et des temps de maintien différents peuvent être utilisés et ces paramètres sont aisément déterminés d'après les résultats satisfaisants obtenus lors d'un essai préalable, en fonction des paramètres de traitements connus pour l'alliage constituant les pièces à traiter. Les superalliages, notamment à base de Ni, Co ou Fe, couramment utilisés dans les applications sur pièces de moteurs aéronautiques conduisent généralement à adopter des températures comprises entre 1050°C et 1150°C et des temps de maintien compris entre deux et cinq heures. Dans l'exemple d'aubes 10 représentées à la figure 1, le courant gazeux symbolisé par les flèches 13 est en contact avec la paroi extérieure des aubes et traverse les circuits internes de refroidissement de l'aube en pénétrant par les évents et les orifices ménagés sur les bords et les parois de l'aube et en sortant par l'ouverture ménagée au niveau du pied de l'aube. La réaction bien connue, notamment par FR-A-1 433 497, d'aluminisation des surfaces par $F_3$ Al, avec dépôt et diffusion d'aluminium se produit ainsi, créant le revêtement protecteur recherché.

Le procédé de protection conforme à l'invention qui vient d'être décrit présente en outre l'avantage de pouvoir être associé sans modification des conditions de mise en oeuvre à un procédé global plus complexe de protection de pièces. En effet, une étape préalable peut être effectuée, permettant de réaliser par tout procédé connu, un dépôt de Cr, Pt ou d'un alliage de type M Cr AlY qui est notamment appliqué sur les surfaces externes des pièces, cette étape étant suivie d'une protection réalisée selon l'invention, notamment une aluminisation.

**Revendications**

1. Procédé de dépôt simultané d'un revêtement protecteur, à la fois sur les surfaces externes et internes de pièces en alliages résistant à chaud, à base de Ni, Co, Fe caractérisé en ce qu'il consiste :

   – (a) à chauffer à une température supérieure à 1000°C une boîte contenant, de manière séparée, les pièces à revêtir, un corps constituant le donneur du métal à déposer, et un corps constituant un activateur, composé au moins de fluorure de chrome $F_3Cr$, sous forme de poudre anhydre, constituant une source de fluor;

– (b) à établir une circulation dans la boîte des vapeurs fluorées obtenues, d'une part après décomposition thermique de $F_3Cr$ et, d'autre part, comportant le fluorure volatil obtenu après passage sur ledit donneur, en introduisant dans la boîte un débit contrôlé d'un gaz porteur réducteur ou neutre, de manière à obtenir, par le contact desdites vapeurs métallisées avec les surfaces externes et internes des pièces, un revêtement protecteur.

2. Procédé selon la revendication 1 dans lequel :
– le donneur est constitué d'un alliage d'aluminium sous forme de granules,
– le fluorure obtenu après passage des vapeurs sur le donneur est $F_3Al$,
– la température de traitement est comprise entre 1050° et 1150°C et sa durée est comprise entre 2 et 5 heures pour obtenir une aluminisation des surfaces internes et externes des pièces.

3. Procédé selon l'une des revendications 1 ou 2 dans lequel une étape préalable comporte l'obtention, par tout procédé connu en soi, d'un revêtement préalable à base de Cr, Pt ou d'un alliage complexe de type M Cr Al Y, notamment sur les surfaces externes des pièces à revêtir.

4. Dispositif de traitement destiné à la mise en oeuvre du procédé conforme à l'une des revendications 1 ou 2 caractérisé en ce qu'il se compose d'une boîte (1) placée dans une enceinte de traitement sous gaz protecteur, connue en soi, et comportant, à sa partie inférieure, une rampe (4), raccordée à une alimentation externe sous débit contrôlé, de distribution d'un gaz porteur réducteur ou neutre, surmontée d'une première grille-support (7) portant de la poudre de fluorure de chrome $F_3Cr$ puis d'une deuxième grille-support (8) portant un donneur, constitué d'un alliage du métal à déposer et à sa partie supérieure, les pièces à revêtir disposées de manière à orienter les orifices de sortie de leurs surfaces internes vers l'admission du courant gazeux en circulation.

5. Dispositif de traitement selon la revendication 4 dans lequel la boîte (1) comporte les aménagements (2a) permettant de disposer à l'extérieur de ladite boîte (1) les parties de pièces non revêtues à l'issue du traitement.

**Claims**

1. Process for simultaneous deposition of a protective coating both on the outer and inner surfaces of articles made of heat-resistant alloys based on Ni, Co, or Fe, characterised in that it consists:
– (a) in heating to a temperature above 1000°C a box containing, separately, the articles to be coated, a body forming the donor of the metal to be deposited and a body forming an activator composed at least of chromium fluoride $CrF_3$, in the form of anhydrous powder, forming a source of fluorine,

– (b) in establishing a circulation in the box of the fluorine-containing vapour obtained, on the one hand, after thermal decomposition of $CrF_3$ and, on the other hand, comprising the volatile fluoride obtained after passing over the said donor, while introducing into the box a controlled flow of a reducing or neutral carrier gas, so as to obtain a protective coating due to the contact of the said metallised vapour with the outer and inner surfaces of the articles.

2. Process according to Claim 1, in which:
– the donor consists of an aluminium alloy in the form of granules,
– the fluoride obtained after passing the vapour over the donor is $AlF_3$,
– the treatment temperature is between 1050° and 1150°C and its duration is between 2 and 5 hours to obtain an aluminising of the inner and outer surfaces of the articles.

3. Process according to either of Claims 1 and 2, in which a preliminary stage comprises obtaining, by any process known per se, a preliminary coating based on Cr, Pt or on a complex alloy of the MCrAlY type, especially on the outer surfaces of the articles to be coated.

4. Device for treatment intended for implementing the process in accordance with either of Claims 1 and 2, characterised in that it consists of a box (1) placed in a treatment enclosure under protective gas, the enclosure being known per se and comprising, in its lower part, a manifold (4) connected to an external supply at a controlled flow rate for distributing a reducing or neutral carrier gas, above which there is a first supporting grid (7) carrying chromium fluoride $CrF_3$ powder and then a second supporting grid (8) carrying a donor, consisting of an alloy of the metal to be deposited and, in its upper part, the articles to be coated arranged so as to point the outlet orifices of their internal surfaces towards the entry of the circulating gas stream.

5. Treatment device according to Claim 4, in which the box (1) comprises arrangements (2a) permitting the uncoated articles to be arranged outside the said box (1) at the end of the treatment.

**Patentansprüche**

1. Verfahren zum gleichzeitigen Aufbringen eines Schutzüberzugs auf die Außen- und Innenflächen von gegen Hitze beständigen Werkstücken aus Legierungen auf der Basis von Ni, Co oder Fe, dadurch gekennzeichnet, daß es umfaßt:

– (a) das Erhitzen eines Gehäuses auf eine Temperatur oberhalb 1000 °C, in dem sich getrennt befinden: die zu überziehenden Werkstücke, eine Masse für die Bildung des niederzuschlagenden Metalls und eine Masse für die Bildung des Aktivators, die zumindest Chromfluorid $CrF_3$ in pulvriger, wasserfreier Form als Fluorquelle enthält, und

– (b) das Zirkulierenlassen von Fluoriddämpfen im Gehäuse, die erhalten worden sind einerseits durch thermische Zersetzung des $CrF_3$ und andererseits durch Hindurchleiten vom flüchtigen Fluorid durch den Metallbildner, unter Einbringen einer geregelten Menge eines reduzierenden oder neutralen Gases, wobei sich durch den Kontakt der metallischen Dämpfe mit den Außen- und Innenflächen ein Schutzüberzug ausbildet.

2. Verfahren gemäß Anspruch 1, wobei der Metallbildner aus einer Aluminiumlegierung in Granulatform besteht, das nach dem Hindurchleiten der Dämpfe durch den Metallbildner gebildete Fluorid $AlF_3$ ist, die Behandlungstemperatur zwischen 1050 °C und 1150 °C liegt und die Behandlungsdauer zum Erhalt einer Aluminisierung der Innen- und Außenflächen zwischen 2 bis 5 Stunden beträgt.

3. Verfahren gemäß Anspruch 1 oder 2, wobei in an sich bekannter Weise ein Vorwegüberzug auf Basis von Cr, Pt oder einer Mischlegierung vom Typ M Cr Al Y, insbesondere auf den Außenflächen der zu überziehenden Werkstücke erfolgt.

4. Vorrichtung zur Durchführung des Verfahrens gemäß den Ansprüchen 1 oder 2, dadurch gekennzeichnet, daß sie besteht aus einem Gehäuse (1), das sich in einem an sich bekannten, unter Schutzgas stehendem Raum befindet und das auf seiner Unterseite eine Rampe (4) trägt, die verbunden ist mit einer außen befindlichen Verteilungsstelle für die geregelte Einspeisung eines reduzierenden oder neutralen Trägergases, einen darüber angeordneten ersten Trägerrost (7) für die Aufnahme des pulverförmigen Chromfluorids $CrF_3$ und einen zweiten Trägerrost (8) für den Metallbildner aus einer Legierung des aufzubringenden Metalls sowie dann in seinem oberen Teil die zu schützenden Werkstücke derart angeordnet enthält, daß die Austrittsöffnungen von deren Innenflächen in Richtung des Eintritts des zirkulierenden Gasstroms zeigen.

5. Vorrichtung gemäß Anspruch 4, wobei das Gehäuse (1) Einrichtungen (2a) aufweist, die es erlauben, an der Außenseite des Gehäuses (1) die im Zuge der Behandlung nicht überzogenen Teile der Werkstücke anzuordnen.

FIG : 1